# EUROPEAN PATENT APPLICATION

(11) **EP 0 581 422 A1**
(43) Date of publication of application: **02.02.1994**
(21) Application number: 93304220.2
(22) Date of filing: 01.06.1993
(51) Int. Cl.: H01L 31/115, H01L 31/117

(54) **PIN diode suitable for use as a neutron dosimeter**

(30) Priority: 27.06.1992 GB 9213719
(71) Applicant: UNITED KINGDOM ATOMIC ENERGY AUTHORITY, Didcot, Oxfordshire OX11 0RA (GB)
(72) Inventor: Totterdell, David Harold John, Didcot, Oxfordshire OX11 ONG (GB); Stockford, Gavin John, Oxford, Oxfordshire OX4 3JS (GB); Harper, Ruth Elizabeth, Didcot, Oxfordshire (GB)
(74) Representative: Mansfield, Peter Turquand

(57) **Abstract**

A PIN diode (10, 35) suitable for use as a neutron dosimeter, and with greater sensitivity than previous dosimeters, comprises a strip or wafer of high resistivity silicon with p and n-doped regions (12,20) on one surface, spaced apart along the strip. The mean carrier lifetime within the high resistivity base region (30) is at least 200 microseconds, while the length of the base region (30) may be more than twice the mean carrier diffusion length. At least the major surfaces of the strip or wafer are oxidised, so minimizing the rate of carrier recombination at the surface. There may be several such doped regions (12, 20) spaced apart along the surface, so forming several PIN diodes of different base lengths (30) and so different neutron sensitivities.

## Description

This invention relates to a PIN diode (i.e. p-type, intrinsic, n-type) which is suitable for use as a fast neutron detector and dosimeter.

It is known to use PIN diodes to detect fast neutrons, the forward voltage drop across such a diode for constant current increasing with fast neutron damage to the base region of the diode, and so being related to the neutron dose. For example US patent number 4 163 240 (Swinehart et a1) describes a PIN diode which can be sensitive to an absorbed dose as low as 1 mGy (0.1 rad), and with a sensitivity at least 1 V/Gy (10 mV/rad). The diode comprises a bar or cylinder of high purity silicon of resistivity in the range 50 ohm cm to 1000 ohm cm, in which the effective minority carrier lifetime is in the range 250 to 750 microseconds. Dopants (phosphorus and boron) are diffused into the two ends to form p and n-type regions. After diffusion, the effective bulk carrier lifetime is said to be preferably greater than about 100 microseconds, and can be measured by an open circuit voltage decay technique. The length of the intrinsic zone, referred to as the "base width", is greater than the width or diameter of the bar, and is said to be typically between 0.75 mm and 3.2 mm. The peak sensitivity indicated for such a PIN diode is about 7 V/Gy. A diode which could be sensitive to smaller doses, and of greater sensitivity, would be very advantageous.

According to the present invention there is provided a PIN diode comprising a base region of high resistivity silicon between a p-type doped region and an n-type doped region, wherein the mean carrier lifetime within the base region is at least 200 microseconds, the diode being of planarform, with at least one p-type region and at least one n-type region spaced apart but at a common surface of a wafer of high resistivity silicon, and the portion of the wafer between the or each p-type region and the or each n-type region providing the or each base region, and at least the major external surfaces of the or each base region are oxidised.

Desirably the diode is fabricated from float zone silicon of initial resistivity above 500 ohm cm, preferably at least 1 kohm cm, and possibly up to 40 kohm cm or more. Desirably the p-type region and the n-type region are both thin, desirably less than 10 micrometres thick and preferably between 0.2 and 5 micrometres, most preferably about 0.5 micrometre thick, as this thin layer can be made without a prolonged heat treatment, so that consequential increases in the conductivity of the base region are minimized. The wafer may be less than 1 mm thick, for example 0.5 mm.

The mean carrier diffusion length is given by the square root of the product of the diffusion coefficient and the mean carrier lifetime. For high resistivity silicon the diffusion coefficient is typically in the range 50 to 80 cm²/sec. Hence if the mean lifetime is 400 microseconds, the diffusion length will be between 1.4 and 1.8 mm. For optimum sensitivity the length of the base region is desirably at least twice the mean carrier diffusion length for the material of which it is made, preferably five or even ten times the diffusion length. In practice, optimizing the sensitivity of the diode is not the only consideration, so that the length of the base region, that is to say the separation of the n-type and the p-type regions on the surface of the wafer, is preferably at least 2 mm, and may be as long as 11 mm.

The invention will now be further described, by way of example only, and with reference to the accompanying drawings in which:
Figure 1 shows a diagrammatic perspective view, not to scale, of a PIN diode; and
Figure 2 shows a diagrammatic perspective view of a modification to the PIN diode of Figure 1.

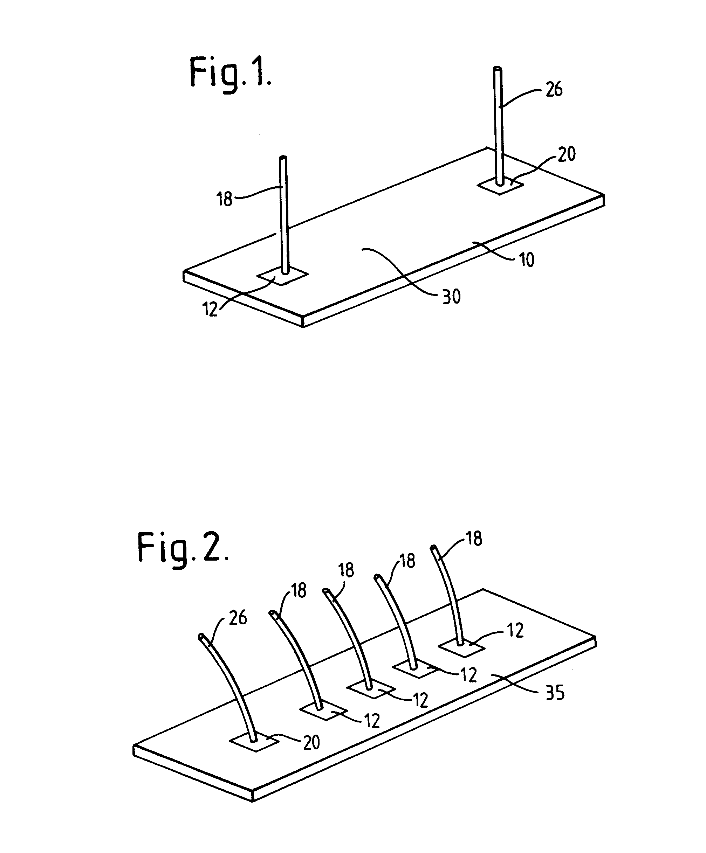

Referring to Figure 1, a diode 10 comprises a rectangular wafer of silicon of length 15 mm, width 5 mm, and 0.5 mm thick. It is fabricated from high resistivity float zone silicon, initially n-type and of resistivity 1 kohm cm. The initial carrier lifetime in this material is greater than 1 ms.

All the surfaces of the wafer are oxidized. Near one end of the wafer the oxide is removed from a square region of side 1.0 mm and the silicon is highly doped with phosphorus to create an n-type region 12 of low resistivity (about 0.001 ohm cm) to a depth of about 0.5 micron, so there is a low impedance junction there. The surface of the n-type region 12 is coated with aluminium of thickness 300 nm, to which a contact wire 18 is bonded. Near the other end of the wafer the oxide is removed from another square region of side 1.0 mm and the silicon is highly doped with boron to create a low resistivity p-type region 20 to a depth of about 0.5 micron, so there is a rectifying junction there. The surface of the p-type region 20 is also coated with aluminium of thickness 300 nm to which a contact wire 26 is bonded. The two doped regions 12 and 20 are 11 mm apart.

The shallow depth of the highly doped regions 12 and 20 can be achieved with only a short high temperature diffusion treatment, or by ion implantation followed by a short anneal, so minimizing the changes to the properties of the intrinsic, high- resistivity region 30 between the doped regions 12 and 20, which is referred to as the base; after manufacture, the carrier lifetime in the intrinsic region 30 (or base) is several hundred microseconds, typically about 500 microseconds. Ion implantation is the preferred process.

In use the PIN diode 10 is connected to a constant current source, and the potential difference between its terminals 18, 26 is measured. It can then be disconnected from the circuit. Exposure of the diode 10 to fast neutrons causes damage to the crystal lattice and leads to the creation of an acceptor level just above the valence band; consequently the recombination rate for carriers in the intrinsic region or base 30 is increased, and the electrical resistance of the base 30 is increased. After exposure, the diode 10 is again connected to the constant current source, and the potential difference between its terminals 18, 26 measured. The increase in this potential difference is a measure of the total dose of fast neutrons received by the diode 10.

In practice it may be more convenient to form several n-type regions 12 and p-type regions 20 on a large area silicon wafer, and then to cut this up into several rectangular diodes 10 as described above. In this case only the top and bottom surfaces of the rectangular wafer of silicon forming a diode 10 are oxidised, as the cut edges are not oxidised. Each diode 10 might then be further treated so as to oxidise the cut edges.

Because at least the major surfaces of the wafer are oxidised, the density of recombinant sites, and so the surface recombination rate, is minimized. It will be appreciated that since the mean carrier diffusion length in the base region 30 of the diode 10 is about 2 mm and the thickness of the wafer is only 0.5 mm the carriers frequently diffuse to the surfaces, so that minimizing the rate of recombination at those surfaces is consequently of considerable importance. Nevertheless the response of the PIN diode to neutron irradiation is believed to be due primarily to changes occurring in the bulkofthe base region 30 ratherthan at its surfaces.

In principle, as large a current as possible should be passed through the diode 10, though in practice considerations of power supply and of diode heating limit the value.

The diode 10 is expected to have a response to neutron irradiation about a hundred times greater than that of known PIN diodes used as dosimeters.

Since the sensitivity of such a PIN diode to neutron irradiation depends upon the length of the base region, being more sensitive the longer the base length, a diode which provides a variety of different lengths of base may be advantageous. Referring now to Figure 2, a PIN diode 35 is shown with many features in common with that of Figure 1, identical features being referred to by the same reference numbers. It comprises a rectangular wafer of silicon, of length 15 mm, width 5 mm, and 0.5 mm thick, made from the same type of high resistivity float zone n-type silicon as used in the diode 10. All the surfaces of the wafer are oxidized.

Near one end of the wafer a p-type region 20 is formed, provided with a contact wire 26, as described above. Similarly, four n-type regions 12, each with a contact wire 18, are formed as described above, spaced apart along the wafer. Contact can thus be made to the wire 26 and to any one of the contact wires 18, so that there are effectively four different PIN diodes of different base lengths, but with a common p-type region 20. The lengths of the base regions are 2 mm, 4 mm, 6 mm, and 8 mm (between nearest edges in the p-type region 20, and the respective n-type regions 12). The diode 35 can be used over a wide range of neutron doses from less than 1 mGy (using the longest base length) up to more than 10 Gy (using the shortest base length).

It should be appreciated that the doped regions 12, 20 may be of different sizes and shapes to those described above, and might for example be rectangular strips oriented transverse to the current direction in the base region. Where there are two or more n-type regions 12 (as in Figure 2) these regions 12 need not all lie on one straight line through the p-type region 20 as long as they are at the desired distances from the p-type region 20, as measurements are made by passing electric current between the p-type region 20 and just one of the regions 12 at any one time. Indeed the p-type region 20 might instead be at the middle of the wafer, and n-type regions 12 be provided on either side of it at different distances. Yet again there might instead be a single n-type region 12, and several spaced-apart p-type regions 20.

## Claims

1. A pin diode (10) comprising a base region (30) of high resistivity silicon between a p-type doped region (20) and an n-type doped region (12) characterised in that the mean carrier lifetime within the base region (30) is at least 200 microseconds, the diode (10) being of planar form, with at least one p-type region (20) and at least one n-type region (12) spaced apart but at a common surface of a wafer of high resistivity silicon, and the portion of the wafer between the or each p-type region (20) and the or each n-type region (12) providing the or each base region (30), and at least the major external surfaces of the or each base region (30) are oxidised.

2. A PIN diode as claimed in Claim 1 wherein the diode is fabricated from float zone silicon of initial resistivity above 500 ohm cm.

3. A PIN diode as claimed in Claim 2 wherein the initial resistivity is at least 1 kohm cm.

4. A PIN diode as claimed in any one of the preceding Claims wherein the or each p-type region (20) and the or each n-type region (12) are less than 10 micrometres thick.

5. A PIN diode as claimed in Claim 4 wherein the or each p-type region and the or each n-type region are between 0.2 and 5 micrometres thick.

6. A PIN diode as claimed in any one of the preceding Claims wherein the separation of the n-type (12) and the p-type (20) region on the surface of the wafer is at least 2 mm.

7. A PIN diode as claimed in Claim 6 wherein the said separation is at least 5 mm.

8. A PIN diode as claimed in any one of Claims 1 to 5 wherein there is a single p-type region (20), and a plurality of n-type regions (12) spaced apart at different separations from the p-type region (20), so as to define a plurality of base regions (30) of different lengths.

9. A PIN diode as claimed in any one of Claims 1 to 5 wherein there is a single n-type region (12), and a plurality of p-type regions (20) spaced apart at different separations from the n-type region (12), so as to define a plurality of base regions of different lengths.

10. A PIN diode as claimed in any one of the preceding Claims wherein all the external surfaces of the or each base region are oxidised.
